Europäisches Patentamt

European Patent Office

Office européen des brevets

(11) Publication number: **0 219 315**
A2

# (12) EUROPEAN PATENT APPLICATION

(21) Application number: 86307816.8

(22) Date of filing: 09.10.86

(51) Int. Cl.⁴: **B 32 B 7/02**
**B 32 B 27/08**

(30) Priority: 09.10.85 US 785808
29.05.86 US 868824

(43) Date of publication of application:
22.04.87 Bulletin 87/17

(84) Designated Contracting States:
AT BE CH DE ES FR GB IT LI NL SE

(71) Applicant: THE DOW CHEMICAL COMPANY
2030 Dow Center Abbott Road P.O. Box 1967
Midland, MI 48640(US)

(72) Inventor: Mott, Charles L.
5111 Perrine Road
Midland Michigan 48640(US)

(74) Representative: Raynor, John et al,
W.H. Beck, Greener & Co 7 Stone Buildings Lincoln's Inn
London WC2A 3SZ(GB)

(54) Antistatic sheet material, package, and method of making.

(57) A flexible sheet material and package formed therefrom is provided. The multilayer sheet material includes a first flexible heat sealable plastic material with antistatic properties on at least the one major surface thereof which first layer is laminated to a second flexible plastic material with an electrically conductive material on the one major surface thereof and antistatic properties on the other major surface thereof.

The multilayer sheet material can include a first inner flexible, heat sealable layer having antistatic properties or intermediate layer having electrically conductive material thereon, and an outer layer of an antistatic material. Additional layers may be added.

EP 0 219 315 A2

Croydon Printing Company Ltd

0219315

ANTISTATIC SHEET MATERIAL, PACKAGE, AND METHOD OF
MAKING

This invention relates to flexible sheet materials used for forming packages or the like for containing electrostatically sensitive components and protecting them from potentially damaging electrostat c charges, and also relates to packages formed therefrom.

As electronic components and units have become increasingly more complex, while achieving ever smaller dimensions, the problem of damage to such components due to electrostatic discharge has become of major concern. The buildup of electrostatic charges on the packages for such components can result in the discharge of a spark which can arc over or otherwise damage or destroy the components.

Similarly, the medical and pharmaceutical industries have requirements for ultraclean instruments and drug substances. Packaging of such instruments and drugs is a problem because buildup of electrostatic charges on the packaging materials attracts dust and other contaminants from the air and surroundings.  Such contaminants may become mixed with the chemicals or drugs causing purity problems. Likewise, when the package is opened or the product poured out a static charge is generated on the product which may attract contaminants.

Accordingly, a number of packages and packaging materials have been developed which have antistatic properties.  These antistatic packages have found wide use in a number of industries including the aerospace, chemical and pharmaceutical, and computer and electronics industries.  Such packages are designed to prevent the buildup of electrostatic charges on the product contained therein, and may also be designed to provide protection against external electric fields.

For example, many packages have been fabricated of plastic films or sheets compounded with or coated with antistatic additives such as quaternary amines, amine salts or soaps, polyethylene glycols or ethers, and the like.  These agents act as humectants, absorbing moisture from the air, to reduce friction within the package and static charge buildup on the package.  However, such antistatic agents may not be permanent (i.e., may migrate to the surface and be lost from the plastic) and are humidity dependent.

Other packages have included one or more layers of conductive material to form a protective envelope or Faraday cage-type structure about the product. A Faraday cage may be defined as an electrostatic shield composed of a continuous me⋯ series of interconnected electrical conductors which surrounds a defined volume of space. Examples of packages utilizing conducting layers include Yenni Jr., et al., U.S. Patent Nos. 4,154,344 and 4,156,751; Petcavich, U.S. Patent No. 4,424,900; and Dedow, U.S. Patent Nos. 4,471,872 and 4,496,406.

However, some of these packages have no provision for closing the package, which leaves the Faraday cage protection incomplete. If adhesive tape or the like is used to close such packages, the act of stripping off the tape to reopen the package may itself create a static charge which is potentially damaging to the contents of the package. Moreover, normal flexing and handling of some prior art packages having conductive layers causes portions of the conductive layers to flake off or become ineffective. These flakes of material themselves are potential sources of contamination to the contents of the packages.

Accordingly, the need still exists in the art for a flexible packaging material and package which has permanent antistatic properties and which protects the contents thereof both from electrostatic charge buildup within the package as well as from external electrical fields and which has a closure means to complete the Faraday cage.

The present invention meets that need by first providing a flexible sheet material which may be formed into a package for protecting electrostatically sensitive electronic components as well sensitive chemicals, ultraclean instruments or other materials for which the buildup of electrostatic charges may cause contamination or damage problems. For the purposes of this specification, reference to electrostatically sensitive components will include not only electronic parts and devices, but also sensitive chemicals and pharmaceuticals as well as other materials or instruments which have the potential of being damaged or contaminated by an electrostatic buildup or discharge.

According to one aspect of the present invention, a multilayer flexible sheet material is provided which includes a first layer of a flexible heat sealable plastic material having primary and secondary major surfaces. Antistatic properties are present on at least the secondary major surface of this layer. The sheet material also includes a second layer of flexible plastic also having primary and secondary major surfaces. An electrically conductive material is on the primary major surface and antistatic properties are present on at least the secondary major surface of this second layer. The

34,157A-F        -4-

layers are bonded together along their respective primary major surfaces, preferably with a suitable adhesive.

According to another aspect of the present invention, a multilayer flexible sheet material is provided which includes an inner layer of a flexible heat sealable plastic. The inner layer may be, for example, a polyolefin or thermoplastic polyurethane. A second intermediate layer may be, for example, a polyester such as polyethylene terephthalate or a copolymer of ethylene and acrylic acid or vinyl acetate. The second layer has electrically conductive material deposited thereon. An outer layer of an antistatic material is coated over the second layer or, alternatively, antistatic material may be incorporated into a polymer which is in turn coated over or laminated to the second layer.

Antistatic properties may then be imparted to the first layer by passing the laminate through an electron beam curing process. Alternatively, antistatic properties for the first layer can be achieved by coating an antistatic material onto the first layer, incorporating an antistatic material into the polymer material of the first layer, or incorporating an antistatic material into a polymer which in turn is coated over or laminated to the first layer.

According to another aspect of the present invention, a multilayer flexible sheet material is

34,157A-F

**0219315**

provided which includes a first layer of a flexible heat sealable plastic material. Antistatic properties are present on at least the first layer. Again, these antistatic properties can be achieved by the procedures discussed above. The sheet material also includes a third layer of flexible plastic also having primary and secondary major surfaces.

A second intermediate layer having an electrically conductive material thereon is sandwiched between the first layer and the primary surface of the third layer. In one embodiment, the first, and/or second, and/or third layers are bonded together with a suitable adhesive.

The flexible sheet material can be readily formed into a package either by folding a sheet onto itself and heat sealing the opposing edges or superimposing two sheets and sealing the opposing edges. Additionally, a closure device may be attached to or incorporated in the package. A preferred closure means is a releasable interlocking plastic zipper, the opposing rib and groove elements of which may be laminated to opposing inner faces of the sheet material adjacent the open end of the package.

A preferred method for fabricating the package includes the steps of providing a first layer of a flexible heat sealable plastic material as described above and coating the surface of the first layer or the primary major surface of the first layer

34,157A-F

with an antistatic material which comprises an acrylate monomer-oligomer mixture containing an alkylether triethyl ammonium sulfate. The antistatic material is cured by exposure to an electron beam. A second layer of flexible plastic material is also provided which has primary and secondary major surfaces. An electrically conductive material such as a metal is deposited on the primary major surface. The deposition may be carried out using well known vacuum deposition or sputtering techniques. Alternatively, a number of conductive materials in sheet or web from are readily commercially available and may be used.

The first and second layers of the flexible sheet may be joined together by coating one or both of these surfaces with either a thermoplastic or thermosetting adhesive and pressing the first and second layers together. The thermosetting adhesive is then cured by exposing it to an electron beam. Surprisingly, curing by exposure to an electron beam causes both exterior facing surfaces of the multilayer flexible sheet material to possess the effect of antistatic properties. This phenomenon occurs both during the initial curing of the antistatic material and again during electron beam curing of the adhesive. Optionally, additional antistatic material may be coated onto the outside of the package to insure optimum performance of the package structure in dissipating static charges.

Alternatively, the antistatic material and adhesive material may be blended together and applied to one or both of the first and second layers and cured simultaneously by exposure to an electron beam. However, it has been found that such a system does not product as good a result (in terms of the strength of the antistatic properties on both secondary major surfaces) as does the preferred process. In yet another alternative embodiment, techniques other than electron beam exposure may be utilized to provide antistatic properties on both secondary major surfaces of the layers. For example, an antistatic material can be compounded into one or both of the layers, and the layers joined using conventional lamination techniques.

The flexible sheet material and process for making it provide a flexible packaging material and package which has permanent antistatic properties on both the interior and exterior facing surfaces of a package. The metal layer is embedded in the multilayer structure and cannot flake off or peel when the package is flexed. It provides a Faraday cage to protect the contents of the package from external electric fields. The optional zipper closure means, which may also contain an antistatic agent and/or semiconductive filler, secures the contents of the package from accidental spillage and brings the opposing faces of the open end of the package into close physical contact which enhances the Faraday cage protection. The result is a package which has permanent antistatic properties, is nonvolatile, non-sluffing, non-humidity dependent, and otherwise offers a number of advantages over pre-existing antistatic packages.

Accordingly, the present invention provides a flexible sheet material, package, and process for making one which has permanent antistatic properties and protects the contents of the package from both electrostatic charge buildup within the package as well from external electric fields. The advantages of the invention will become apparent from the following detailed description, the accompanying drawings, and the appended claims.

Fig. 1 is a perspective view of a package formed in connection with the teachings of the present invention;

Fig. 2 is a cross-sectional view taken along line 2-22 in Fig. 1 illustrating in detail the optional zipper closure for the package;

Fig. 3 is an enlarged cross-sectional view through the sheet material used to form the package of Fig. 1;

Fig. 3A is an enlarged cross-sectional view through one embodiment of the sheet material used to form the package of Fig. 1;

Fig. 4 is an enlarged cross-sectional vie through another embodiment of the sheet material used to form the package of Fig. 1;

34,157A-F                    -9-

Fig. 5 is an enlarged cross-sectional view through another embodiment of the sheet material used to form the package of Fig. 1;

Fig. 6 is an enlarged cross-sectional view through another embodiment of the sheet material used to from the package of Fig. 1;

Fig. 7 is an enlarged cross-sectional view through yet another embodiment of the sheet material used to form the package of Fig. 1; and

Fig. 8 is an enlarged cross-sectional view through still yet another embodiment of the sheet material used to form the package of Fig. 1.

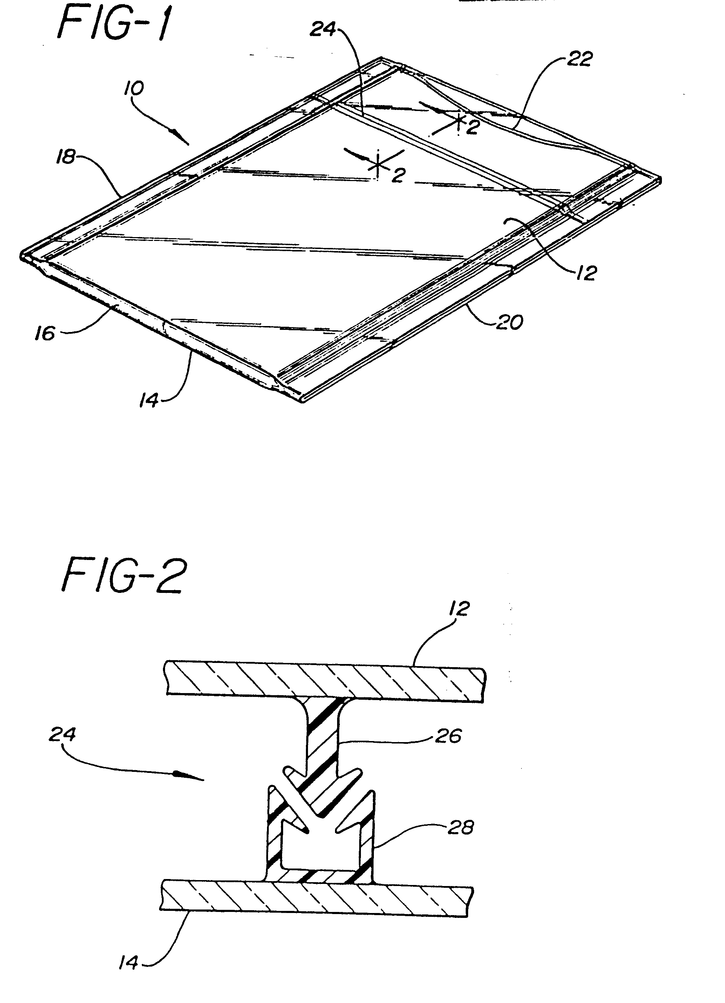

Referring now to Fig. 1, there is illustrated a package 10 which is the preferred from of package formed in accordance with the present invention. Other package, bag, pouches, and forms, including thermoformed containers and laminated containers, may be prepared from the flexible sheet material of the present invention. Package 10 is shown as generally rectangular in shape, but may be formed into any convenient shape or size depending on the component or material to be contained therein. Package 10 includes two opposing walls 12 and 14 which comprise the multilayer flexible sheet material of the present invention described in greater detail below. In the preferred embodiment, package 10 is formed by applying releasable and reclosable closure 24 to a web of the flexible sheet material, and folding the web of the flexible sheet material upon itself at fold line 16 to bring complementary rib and groove

34,157A-F                    --10-

**0219315**

elements 26 and 28 into alignment. Opposing edges 18 and 20 are then heat sealed together and packages 10 severed from the web in a conventional manner.

As schematically illustrated in Fig. 2, closure 24, adjacent opening 22, comprises an interlocking zipper having complimentary rib and groove elements 26 and 28, respectively. While single rib and groove elements have been illustrated fro simplicity, it will be apparent to those skilled in the art that other structures such as so-called Wide Track zippers with a plurality of complimentary rib and groove elements may be used as described in Published British Patent Application No. 2133462 published July 25, 1984. Optional closure 24 is preferably extruded or laminated onto the sheet material prior to the formation of package 10. Preferably, an antistatic material and/or semiconductive filler is incorporated into closure 24.

Closure 24 may be used to enhance the Faraday-cage effect of the package by providing a electrical path through the zipper to opposite walls of the package. Preferably, closure 24 has a surface resistivity in the range of from $10^{13}$ to $10^2$ ohms/sq. Closure 24 is located approximately 0.24 to 4 inches (0.6 to 10.2 cm), and preferably 0.5 to 1.5 inches (1.2 to 3.8 cm), from open end 22 of package 10. Closure 24 may be omitted, or alternate closure means used, if so desired.

34,157A-F                    -11-

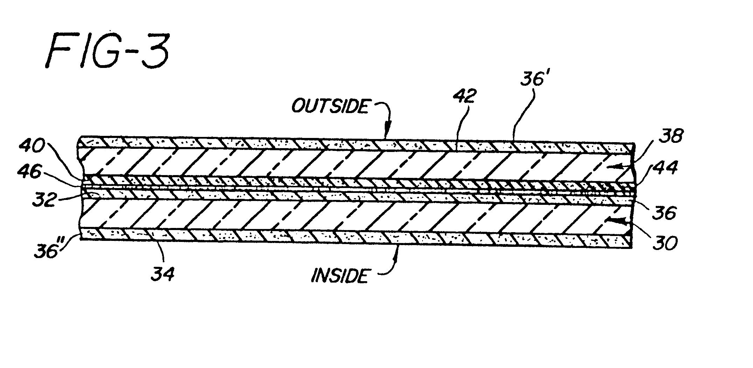

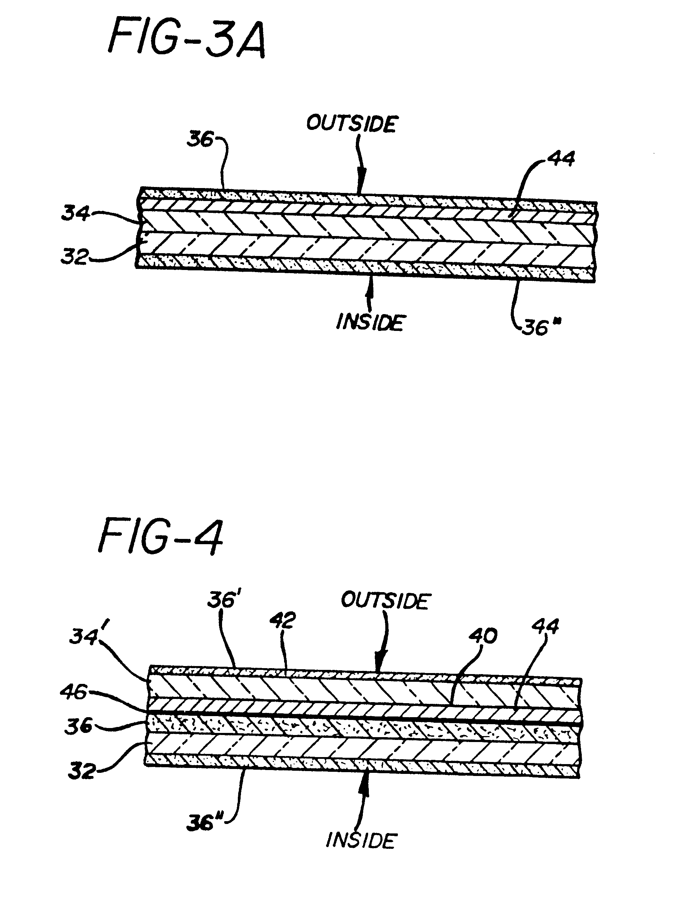

One embodiment of the multilayer flexible sheet material of the present invention which is used to form walls 12 and 14 of package 10 is illustrated in enlarged cross section in Fig. 3 and Fig. 3A. The legends "Inside" and "Outside" have been added to the drawing to aid in the understanding of the invention. The side of the material labeled "Inside" is the inwardly facing surface of the material designed to be in contact with the contents of package 10 which is formed as described above. The "Inside" may also have closure 24 applied to it as illustrated in Fig. 2. The side of the material labeled "Outside" is the exterior or outwardly facing surface of the multilayer material.

In the embodiment illustrated in Fig. 3, the sheet material is formed by the lamination of two principal layers. First layer 30 is formed of a flexible heat sealable plastic having primary and secondary major surfaces 32 and 34, respectively. First layer 30 has an antistatic material 36 on its primary major surface 32. First layer 30 also has antistatic properties (illustrated by numeral 36") on at least secondary major surface 34. By "antistatic" material or agent, it is meant that the material or agent has properties which prevent the buildup of or cause the dissipation of static charges. Antistatic material 36 provides a surface conductivity in the range from about $10^6$ to about $10^{13}$ ohms/sq., and preferably about $10^8$ to about $10^{11}$ ohms/sq.

First layer 30 is preferably a polyolefin such as polyethylene (either high or low density, branched or linear) or polypropylene. Additionally, layer 30 may be a copolymer of ethylene or propylene with a copolymerizable monomer. Preferred copolymers include copolymers of ethylene with either vinyl alcohol or vinyl acetate, ethylene-acrylic acid copolymers, and ethylene-carbon monoxide copolymers. Layer 30 may also comprise blends or mixtures of these polyolefin homopolymers and copolymers.

Alternatively, first layer 30 need not be a polyolefin but simply be a heat sealable plastic such as a heat sealable polyester. One example of such a material is polyethylene terephthalate glycol (PETG). Additionally, first layer 30 need not be a single unitary layer but may be comprised of a number of plies as long as the ply adjacent the "Inside" surface of the laminate, i.e., secondary major surface 34 is heat sealable. Thus, it may be desirable to incorporate other polymers having properties such as toughness, resistance to penetration, chemical resistance, or the like into first layer 30. For example, a nylon ply can be incorporated with one or more polyolefin plies to impart additional toughness to layer 30. This nylon ply may be coextruded with a polyethylene ply or otherwise laminated thereto, or alternatively may be sandwiched between two polyethylene plies.

Second layer 38 is formed of a flexible plastic having primary and secondary major surfaces 40 and 42, respectively. Second layer 38 has deposited on its primary major surface 40, a layer of an electrically conductive material 44. The secondary major surface 42 has antistatic properties illustrated by numeral 36'.

Layer 38 is preferably a polyester, but may also be a polyolefin such as polyethylene or polypropylene polymers or copolymers or other polymeric materials. Additionally, layer 38 may comprise blends or mixtures of such polymers, or may include two or more plies of coextruded polymers.

Electrically conductive layer 44 is preferably formed by depositing a thin layer of metal on primary major surface 40 of layer 38. This deposition may be accomplished through the use of conventional vapor deposition or sputtering techniques. Preferred metals include aluminum, stainless steel, nickel, copper, and mixtures thereof. The primary major surface 40 of layer 38 may be pretreated to render it more receptive to metallization. Optionally, electrically conductive layer 44 may be a coated or laminated metal grid, a metal filled plastic film, or other conductive material.

Layer 44, if vacuum deposited or sputtered, is preferably about 50 to about 200 Angstroms thick,

34,157A-F            -14-

and most preferably about 100 Angstroms thick. Its surface resistivity is preferably about 100 ohms/sq. The coating may be discontinuous and/or have pinholes therein with no substantial adverse effect on the Faraday-cage structure which results when the package is formed.

Alternatively, metallized polyester films and sheets are readily commercially available from a number of suppliers and may be utilized in the practice of the present invention. It is preferred that the combination of layers 38, 44 and 30 be partially transparent or transparent to permit visual inspection of the contents of the package without the need for opening the package. Opening of the package outside of a controlled environment which allows for discharge of any static charge buildup may be detrimental. Accordingly, the ability to make a visual inspection of a packaged component, including any part or control numbers included in the package, is desirable. It is also possible to have one wall of the package partially transparent or transparent (through which the component may be inspected) and the other wall opaque. For example, a cushioning layer, such as a foamed plastic film, may be laminated to, or included in, wall 12 or 14 while the other wall remains as described. In the preferred embodiment where both walls are transparent, the walls of package 10 are made up of the two principal layers. The two layers 30 and 38 are bonded together along their respective primary major surfaces through the use of an adhesive 46. Adhesive 46 is preferably a thermosetting epoxy or urethane adhesive which is curable by exposure to an electron beam. Further, it is desirable that the adhesive be a solvent-free, 100 percent solids material; although other forms of adhesive may be used.

In the embodiment illustrated in Fig. 3A, the sheet material may be formed by an extrusion-coating process. This offers a number of advantages over processes which involve lamination steps. First layer 32 is formed of a flexible heat sealable plastic. Second layer 34 is coextruded with first layer 32. An electrically conductive layer 44 is deposited on second layer 34. An antistatic material 36 is coated over conductive layer 44. By "antistatic" material or agent, it is meant that the material or agent has properties which prevent the buildup of or cause the dissipation of static charges. Antistatic material 36 provides a surface conductivity in the range from $10^6$ to $10^{13}$ ohms/sq., and preferably $10^8$ to $10^{11}$ ohms/sq. First layer 32 also has antistatic properties (illustrated by numeral 36") on its "Inside" surface. Such antistatic properties may be created by electron beam curing antistatic material 36 to cause antistatic properties 36" to appear on the Inside surface of layer 32.

Alternatively, antistatic properties 36" can be achieved by coating an antistatic material onto

34,157A-F                          -16-

first layer 32, incorporating an antistatic material into the polymer which makes up first layer 32, or incorporating an antistatic material into a polymer which in turn is coated over or laminated to first layer 32. For example, a thermoplastic polyurethane having antistatic properties may be coated over or laminated to first layer 32.

As mentioned layers 32 and 34 are preferably coextruded ones, although other known methods of providing those layers may be utilized. First layer 32 is a heat sealable material and is preferably a polyolefin such as polyethylene (either high or low density, branched or linear) or polypropylene homopolymers or copolymers. First layer 32 may also include copolymers of ethylene and vinyl acetate, copolymers of ethylene and carbon monoxide, copolymers of ethylene and acrylic acid and blends or mixtures of such polyolefins. Alternatively, first layer 32 may be a thermoplastic polyurethane.

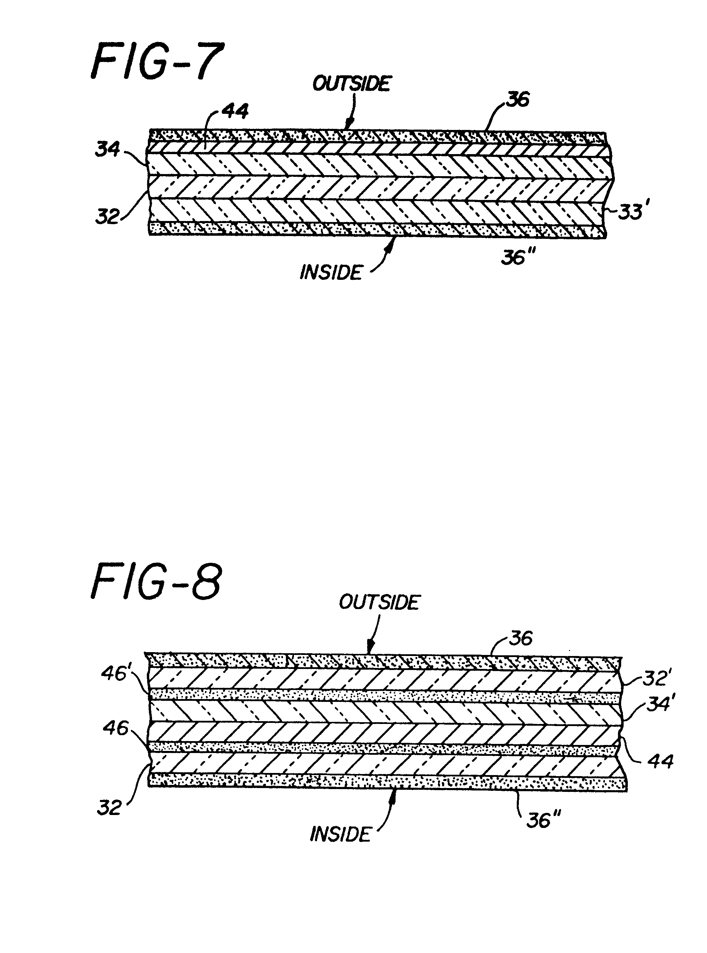

Second layer 34 is preferably a copolymer of ethylene and acrylic acid or vinyl acetate. Alternatively, second layer 34' (as shown in Figs. 4 and 8) may be a polyester such as polyethylene terephthalate. While electrically conductive materials such as metals will not bond or adhere directly to a polyurethane or polyolefin such as polyethylene, it has been found that such conductive materials will bond direcly to ethylene-acrylic acid copolymers, ethylene-vinyl acetate copolymers, and polyesters.

Preferably, layer 32 is a blend of about 0-25 percent high density polyethylene and 25 percent - 100 percent linear low density polyethylene, by weight, and second layer 34 is a copolymer of ethylene and from 2-15 percent, and more preferably 2-5 percent, acrylic acid. A material such as preferred layers 32, 34 is a coextruded material commercially available from The Dow Chemical Company under the designation Dow Adhesive Film. Additionally, the laminate may comprise an additional number of layers as long as the layer adjacent the "Inside" surface of the laminate, i.e., layer 32, is heat sealable, there is an intermediate layer 34 bearing a electrically conductive layer 44 and there is an outer layer 36 of antistatic material or a material having antistatic properties.

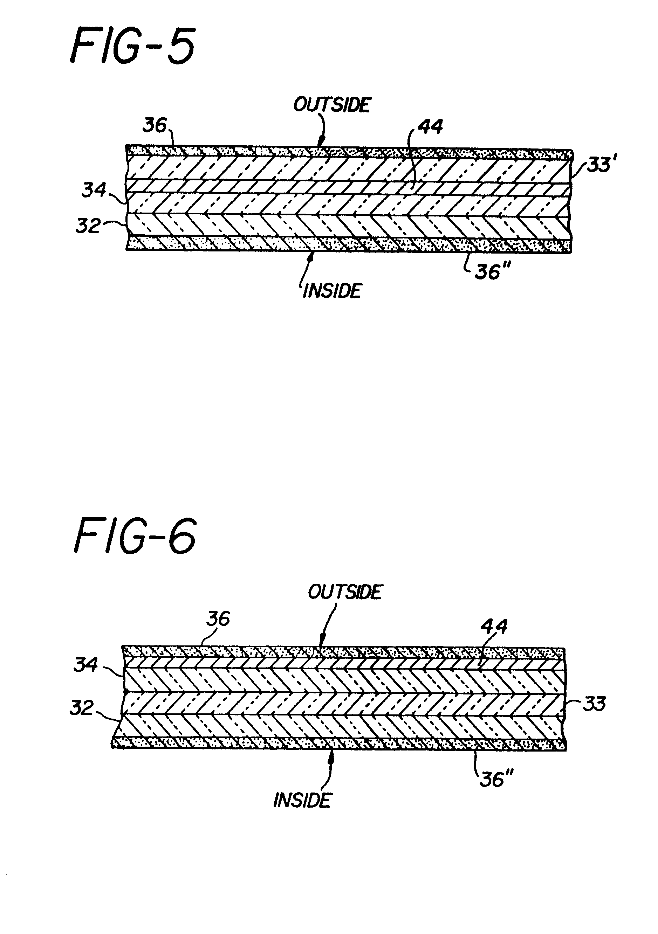

Thus, it may be desirable to incorporate other polymers having properties such as toughness, resistance to penetration, chemical resistance, or the like into the laminate. For example a nylon layer 33 (Fig. 6) or a polyurethane layer 33' (Figs. 5 and 7) may be incorporated. Likewise, adhesive layers 46 (Figs. 4 and 8) and 46' (Fig. 8) may also be used, preferably when second layer 34' is a polyester.

The preferred antistatic material for use in the present invention is an acrylate monomer-oligomer mixture containing an alkylether triethyl ammonium
sulfate available from Metallized Products, Inc.,
Winchester, Massachusetts, under the name Staticure.
the material is curable by exposure to an electron
beam and cures to a permanent, nonbleeding coating
which is not dependent on humidity for its antistatic
effect. Further details concerning this antistatic
material may be found in British Patent Application
No. 2,156,362, published October 9, 1985.

Alternatively, other known antistatic agents
such as quaternary ammonium compounds or carbon may
be utilized. These antistatic agents may be
compounded with the polymers making up one or more
layers of the sheet material, may be coated onto
respective "Inside" and/or "Outside" surfaces of the
sheet material, or may be compounded with a polymer
which is then itself coated onto the respective
"Inside" and/or "Outside" surfaces of the sheet
material.

Electrically conductive layer 44 is
preferably formed by depositing a thin layer of metal
on layer 34 or 34'. This deposition may be
accomplished through the use of conventional vapor
deposition or sputtering techniques. Preferred
metals include aluminum, stainless steel, nickel,
copper, and mixtures thereof. Layer 34 or 34' may be
pretreated to render it more receptive to
metallization. Optionally, electrically conductive
layer 44 may be a coated or laminated metal grid or mesh, a metal filled plastic film, or other conductive material.

Layer 44, if vacuum deposited or sputtered, is preferably 50 to 200 Angstroms thick, and most preferably 100 Angstroms thick. Its surface resistivity is preferably about 100 ohms/sq. The coating may be discontinuous and/or have pinholes therein with no substantial adverse effect on the Faraday-cage structure which results when the package is formed.

It is preferred that the combination of layers in the laminate be partially transparent or transparent to permit visual inspection of the contents of the package without the need for opening the package. Opening of the package outside of a controlled environment which allows for discharge of any static charge buildup maybe detrimental. Accordingly, the ability to make a visual inspection of a packaged component, including any part or control numbers included in the package, is desirable. It is also possible to have one wall of the package partially transparent or transparent (through which the component may be inspected) and the other wall opaque. For example, a cushioning layer, such as a foamed plastic film, may be laminated to, or included in, wall 12 or 14 while the other wall remains as described. In the preferred embodiment where both walls are transparent, the walls of package 10 are made up of the two principal layers.

In the alternative embodiment illustrated in Fig. 4, where like elements are identified by like reference numerals, the sheet material comprises a first layer 32, a second layer 34', and a conductive layer 44.

Second layer 34' is formed of a flexible plastic having primary and secondary major surfaces 40 and 42, respectively. Second layer 34 has deposited on its primary major surface 40, a layer of an electrically conductive material 44. The secondary major surface 42 has antistatic properties illustrated by numeral 36'.

In this instance second layer 34' is preferably a polyester, but may also be a thermoplastic polyurethane or a polyolefin such as polyethylene or polypropylene polymers or copolymers, including copolymers of ethylene and acrylic acid or vinyl acetate. Additionally, layer 34' may comprise blends or mixtures of such polymers, or may include two or more plies of coextruded polymers. Optional layer 38 may be a copolymer of ethylene and acrylic and or vinyl acetate in which case layers 32 and 38, like layers 32 and 34 of Fig. 3A, may be coextruded material available from the Dow Chemical Company under the designation Dow Adhesive Film.

The two layers 32 and 34' may be bonded together along their respective primary major surfaces through the use of an adhesive 46. Adhesive 46 is preferably a thermosetting epoxy or urethane adhesive which is curable by exposure to an electron beam. Adhesive 46 may also be a thermoplastic adhesive and may have an antistatic material incorporated in it. Further, it is desirable that the adhesive be a solvent-free, 100 percent solids material although other forms of adhesive may be used.

Alternatively, conductive layer 44 may be bonded directly to layer 38 by hot roll lamination or as described above, with respect to the embodiment illustrated in Fig. 3A.

Thus, a preferred method of making the multilayer flexible sheet material of the embodiment illustrated in Fig. 4 and Fig. 3 includes the following steps. Layer 32 (layer 30 in Fig. 3) is coated with antistatic material 36, and the antistatic material is cured by exposure to an electron beam. During this curing step antistatic properties are produced on both major surfaces of layer 32 (layer 30 in Fig. 3). This phenomenon is discussed in "EB-curable Coating" Is Clear Cure For Static", _Converting Magazine_, March 1985, and "Electron Beam Radiation Cured Coatings for Static Control", _Evaluation engineering_, September 1985. That is, the "Inside" surface (surface 34 in Fig. 3) of layer 30, following curing of antistatic material 36, now shows antistatic properties (illustrated by numeral 36") even though no antistatic material was originally coated directly thereon. Of course, it is possible in an additional step to also coat antistatic material on the "Inside" surface (surface 34 in Fig. 3) of layer 32.

Second layer 34' (layer 38 in Fig. 3), with electrically conductive layer 44 thereon, is then joined with layer 32 (layer 30 in Fig. 3) using adhesive 46. As described above, electrically conductive layer 44 may be deposited on layer 34' (layer 38 in Fig. 3) by sputtering or vacuum deposition. Alternatively, a metallized plastic which is commercially available may be utilized.

Adhesive 46 may be applied either to electrically conductive layer 44 or antistatic material 36 or both. It is preferably applied by a gravure coating process, although it may be sprayed or otherwise coated using conventional techniques which are suitable for coating 100 percent solids materials. After application of adhesive 46 and lamination of layers 32 and 34' (layers 30 and 38 in Fig. 3) using pressure rolls or the like, the laminate is again exposed to an electron beam to cure the adhesive. This second curing step causes antistatic properties to appear on the "Outside" surface 42 of layer 34' (exterior facing surface 42 of layer 38 in Fig. 3). Surface 42, following curing

-24-

of the adhesive 46, now shows antistatic properties (illustrated by numeral 36') even though no antistatic material was originally coated directly thereon. Again, it is possible in an additional step to coat antistatic material on surface 42.

In an alternative procedure, antistatic material 36 may be blended with adhesive 46 and applied to one or both layers. then, a single curing step utilizing an electron beam is performed which cures adhesive 46 and results in antistatic properties appearing on both the inner and exterior faces of the laminated sheet material; although, as mentioned, the results achieved with this alternative procedure are not as good as those achieved with the preferred process.

As mentioned, the preferred method for making the sheet material of the embodiment illustrated in Fig. 3A is advantageous in that no adhesive or lamination is required. First layer 32 and second layer 34 are coextruded second layer 34 has deposited thereon electrically conductive layer 44 using a suitable vacuum deposition or sputtering technique. Layer 44 will bond to layer 34 of an ethylene-acrylic acid or ethylene-vinyl acetate copolymer. Then, a layer of antistatic material 36 is coated onto layer 44 in the manner described above. The antistatic material 36 is then cured utilizing an electron beam. The curing step causes antistatic properties to appear on the "Inside" facing surface of layer 32, illustrated by numeral 36", even though no antistatic material was originally coated directly thereon. Again, as discussed previously, an additional coating step may be performed to apply antistatic material on the "Inside" facing surface of layer 32. That process is illustrated by Example 2.

The structures shown in Figs. 5 and 7 are similar to the one shown in Fig. 3A except that a layer 33' is included. Preferably polyurethane layer 33' is a thermoplastic polyurethane which may be hot roll laminated over conductive layer 44 (Fig. 5) prior to being coated with antistatic material 36 or hot roll laminated to thermoplastic layer 32 (Fig. 7). In the latter instance, thermoplastic polyurethane layer 33' serves as the "Inside" heat sealable layer. Alternatively, the layers 44 and 32 can be interchanged.

The structure shown in Fig. 6 is also similar to that of Fig. 3A except that a third layer 33, which may be nylon for example, is preferably coextruded along with, and between, layers 32 and 34.

The structure shown in Fig. 8 is similar to the one shown in Fig. 4 except that an additional heat sealable layer 32' is adhered over second layer 34" by use of adhesive 46'. In a "sandwich" structure of that type, either surface may be used as the "Outside" or "Inside" because both outer layers of the laminate are a heat sealable layer (32 or 32') having antistatic properties (36 or 36').

34,157A-F                    -25-

In order that the invention may be more readily understood, reference is made to the following examples, which are intended to illustrate the invention but are not to be taken as limiting the scope thereof.

Example 1

Preparation of First Layer 30 (Figure 3)

A common insulative low density 2 mil (0.05 mm) polyethylene film was gravure coated on one side with Staticure antistatic electron beam curable coating from Metallized Products to an approximate 0.1 mil (0.0025 mm) thickness. The coated film was immediately passed through an electron beam (Energy Sciences curtain type) at 200 ft./min. (1.02 m/s) and exposed to 3 megarads (0.03 megagrays).

Measurement of surface resistivity according to (ASTM D-257 method) of the uncoated film originally was greater than $10^{14}$ ohms per square on both surfaces (insulative).

The surface resistivity after coating and electron beam treatment was measured to be $2.3 \times 10^{11}$ ohms per square (inner surface) and $5.5 \times 10^{10}$ ohms per square (outer surface).

## Preparation of Second Layer 38 (Figure 3)

A one mil (0.025) polyester (polyethylene terephthalate (mylar) film was coated with aluminum at a controlled density of 100 angstroms resulting in a partially transparent metallized film with surface resistivity of 100 ohms per square on the metallized surface and greater than $10^{14}$ ohms per square on the non-metallized surface.

## Preparation of Laminated Flexible Sheet Material

The aluminum side of the polyester was gravure coated to an approximate thickness of 0.1 mil (0.025 mm) with a thermoset electron beam curable adhesive (epoxy type). The previously coated side of the polyethylene film in step 1 was now brought in contact with the adhesive and both films passed through nip rolls at ambient temperature which fed the two now joined films through an electron beam curtain (3 megarads) at 200 ft./min. (1.02 m/s).

The laminated film structure was wound on a core prior to subsequent conversion. The resultant material is represented in Figure 3. Surface resistivity measurements [ASTM D-257 method] on the polyester outer surface was measured to be $2 \times 10^{12}$ ohms/square. The surface resistivity was measured on the inner heat seal surface and found to be $3 \times 10^{12}$ ohms/square.

34,157A-F

## Preparation of Package 10

The above mentioned film was now placed on an unwind stand for subsequent application of closures on the heat sealable inside surface. The cross section of the final closure was represented schematically in Figure 2. The film web was threaded through a series of rolls to avoid wrinkles. Low density polyethylene resin previously compounded to contain an antistat agent such as Armostat 350 was extruded through dies designed to result in closures shaped similar to rib element 26 and the other groove element 28 of Figure 2 and onto the unheated heat seal layer side of the film mentioned.

The web (walls 12 and 14), now containing both rib element 26 and groove element 28 was folded and joined at the closure prior to side seam heat sealing and cutting into bags. Bar type heat seals were utilized for side seam seals with a temperature range of 230° to 330°F (110° to 165.6°C) and packages 10 were severed from the web. No further work was required to the product and it was now ready for use.

## Example 2

A package adapted to receive and protect an electrostatically sensitive component was produced in accordance with the present invention as follows. A three mil (0.076 mm) thick flexible two-ply film was selected for use as the inner layer of the package. One ply of the film comprised a copolymer of ethylene and from 2 to 5 percent acrylic acid while the other ply of the film was a polyethylene homopolymer. The film had a surface resistivity on both surfaces of greater than $10^{14}$ ohms/square.

The ethylene-acrylic acid copolymer surface was vacuum metallized with aluminum using a controlled density, wire wound vacuum metallization technique. The final coating thickness was approximately 100 Angstroms. The aluminum layer had a surface resistivity of 50 to 100 ohms/square. The aluminum layer had 40 to 60 percent light transmission characteristics.

The aluminum layer was then coated with a radiation curable 100 percent solids acrylate monomer-oligomer mixture which contained 15 parts by weight of a triethyl-alkyl ether ammonium sulfate antistatic agent (commercially available from Emery Industries under the designation Emerstat 6660). The mixture was applied by a gravure coating process to a coat weight of 0.5-2.0 lbs./ream. The coating on the film was then exposed to radiation by an electron beam. The electron beam was applied by an Energy Sciences curtain-type device. The film traveled under the electron beam at a speed of 200 feet/minute (1.02 m/s) at an exposure of 3 megarads. The film was then rewound onto a mill roll.

After subsequent aging on the roll, surface resistivities on both surfaces of the film were measured. The antistatic coated surface of the film exhibited a resistivity of less than $1 \times 10^{12}$ ohms/square, while the uncoated surface exhibited a resistivity of less than $1 \times 10^{13}$ ohms/square. Additionally, the time to dissipate a positive or negative 5000 volt static charge to 50 volts was measured. The film, prior to being coated with the antistatic agent, took more than 3 minutes to dissipate a 5000 volt charge, while the coated film took less than 0.4 seconds to dissipate the same charge.

The coated film, as produced above, was then unwound for fabrication into packages. Mating rib and groove fasteners were extruded from low density polyethylene and then applied to opposing inner heat sealable surfaces of the film as taught in copending U.S. Application Serial No. 753,191, filed July 9, 1985, and assigned to the same assignee as the present invention. The cross-section of the final closure elements is represented schematically in Figure 2. Application of the fastener elements was accomplished by threading the film through a series of rolls to avoid wrinkles. The low density polyethylene resin, which had been compounded to contain an antistatic agent such as Armostat 350 was extruded onto the unheated inner heat sealable film surfaces.

34,157A-F                                   -30-

The web (walls 12 and 14), now containing both rib element 26 and groove element 28, was then folded and joined at the fasteners prior to side seam heat sealing and severing into individual zippered packages. Bar-type heat seals were used for side seam seals with a temperature range of 230° to 330°F (110° to 165.5°C) and packages 10 were severed from the film web.

Example 3

A thermoplastic urethane polymer, prepared in accordance with copending U.S. Application Serial No. 785,294, filed October 7, 1985, and assigned to the same assignee as the present invention, was compounded with an antistatic agent. The antistatic agent is 1.0 percent by weight sodium thiocyanate. The polymer was then fabricated into a film having a thickness of 2.5 mils (0.06 mm). The surface resistivity of the film was measured to be less than $10^{12}$ ohms/square.

The urethane polymer film was then laminated to the metallized film of Example 2. The urethane film was joined to the metallized surface of the film by hot roll lamination resulting in a laminate as illustrated in Figure 5. Zipper fastener profiles were extruded from the same urethane polymer onto the laminated structure by the process taught in copending U.S. Application Serial No. 753,191, filed July 9, 1985, and assigned to the same assignee as the present invention.

The laminated structure was formed into individual packages as previously described in Example 2. The resulting packages exhibited good puncture and abrasion resistance. Such packages are especially useful to protect electronic circuit boards and other electronic components having exposed wire ends.

Having described the invention in detail and by reference to preferred embodiments thereof, it will be apparent that modification and variations are possible without departing from the scope of the invention defined in the appended claims.

1.      A flexible sheet material adaptable for forming a package, bag, pouch, or the like for containing electrostatically sensitive components comprising;

(a)   a first layer of a flexible heat sealable plastic material having primary and secondary major surfaces with antistatic properties on at least said secondary major surface thereof; and

(b)   a second layer of a flexible plastic material having primary and secondary major surfaces with an electrically conductive material on said primary major surface and with antistatic properties on at least said secondary major surface, said first and second layers of material being bonded together along said primary major surfaces, respectively, of said first and second layers.

2.   The flexible sheet material of Claim 1 further including an antistatic material on said primary major surface of said first layer.

3.   The flexible sheet material of Claim 1 in which said first layer is selected from the group consisting of polyethylene, polypropylene, copolymers of ethylene or propylene with a copolymerizable monomer, polyethylene terephthalate glycol and blends or mixtures thereof.

4. The flexible sheet material of Claim 1 in which said first layer comprises a plurality of plies of polymeric materials, with at least one of said plies comprising nylon, and with the further proviso that the polymeric material forming said second major surface of said first layer is heat sealable.

5. The flexible sheet material of Claim 1 in which said second layer is selected from the group consisting of polyethylene and polypropylene polymers and copolymers, polyester, and blends of mixtures thereof.

6. The flexible sheet material of Claim 1 in which said first and second layers are bonded together with a thermosetting adhesive.

7. The flexible sheet material of Claim 6 in which said thermosetting adhesive contains an antistatic material.

8. A flexible sheet material adaptable for forming a package, bag, pouch, or the like for containing electrostatically sensitive components comprising:

(a) a first inner layer of a flexible plastic material, said first inner layer being heat sealable,

(b) a second intermediate layer having an electrically conductive material deposited thereon, and

(c) an outer layer of an antistatic material, said outer layer being located on the side of said second layer opposite said first inner layer.

9. The flexible sheet material of Claim 8 in which said inner layer has antistatic properties.

10. The flexible sheet material of Claim 9 in which said inner layer is a polyolefin or thermoplastic polyurethane and said second layer is a copolymer of ethylene and acrylic acid or vinyl acetate.

11. The flexible sheet material of Claim 10 in which said first and second layers are formed by a coextrusion process.

12. The flexible sheet material of Claim 9 including a third layer comprising nylon said third layer being sandwiched between said second and first layers.

13. A flexible sheet material adaptable for forming a package, bag, pouch, or the like for containing electrostatically sensitive components comprising:

34,157A-F                    -35-

(a)  a first inner layer of a flexible, heat sealable plastic material having antistatic properties;

(b)  a second layer of a flexible plastic material having an electrically conductive material deposited thereon; and

(c)  a layer of adhesive between said first layer and said second layer bonding said first layer to said second layer, and

(d)  an outer antistatic surface, and outer surface being located on the side of said second layer opposite said first inner layer.

14.  The flexible sheet material of Claim 13 in which said first layer is a polyolefin and said second layer is a polyester.

15.  The flexible sheet material of Claim 11 including a third layer which is selected from the group consisting of films of polyester, polyolefin polymers or copolymers, thermoplastic polyurethane, copolymers of ethylene with acrylic acid or vinyl acetate, and blends.

16.  The flexible sheet material of Claim 15 in which said second layer is bonded to said third layer with an adhesive.

17.  The flexible sheet material of Claim 1, 8 or 13 in which said electrically conductive material is selected from the group consisting of aluminum, stainless steel, nickel, copper, and mixtures thereof.

18. The flexible sheet material of Claim 13 including a layer of antistatic material.

19. The flexible sheet material of Claim 2, 9 or 18 wherein said antistatic material is cured acrylate monomer-oligomer mixture containing an alkylether triethyl ammonium sulfate.

20. A package adapted to receive and protect an electrostatically sensitive component, the walls of said package formed of a flexible sheet material of Claim 1, 8 or 13.

21. The package of Claim 20 including releasable, interlocking closure means on opposing inner faces of one end of said walls.

22. A method of fabricating a multilayer flexible sheet material adaptable for forming a package, bag, pouch, or the like for containing electrostatically sensitive components comprising the steps of:

(a) providing a first layer of a flexible, electrically insulating, heat sealable plastic material having primary and secondary major surfaces;

(b) coating said primary major surface of said first layer with an antistatic material comprising an acrylate monomer-oligomer mixture containing an alkylether triethyl ammonium sulfate;

(c) curing said antistatic material by exposing it to an electron beam;

(d) providing a second layer of a flexible plastic material having primary and secondary major surfaces with an electrically conductive material deposited on said primary major surface;

(e) joining said first and second layers along their primary major surfaces by coating one or both of said primary major surfaces with a thermosetting adhesive and pressing said first and second layers together; and

(f) curing said thermosetting adhesive by exposing it to an electron beam, said curing steps causing said antistatic material to provide antistatic properties to said secondary major surfaces of said layers.

23. A method of fabricating a multilayer flexible sheet material adaptable for forming a package, bag, pouch, or the like for containing electrostatically sensitive components comprising the steps of:

(a) providing first inner layer of a flexible, heat sealable plastic material and a coextruded second layer of flexible plastic material,

(b) depositing an electrically conductive material on said second layer,

(c) coating an outer layer of antistatic material over said electrically conductive material, said antistatic material comprising an electron beam curable mixture, and

(d)  curing said antistatic material by exposing it to an electron beam, said curing step causing said antistatic material to provide antistatic properties to said first inner layer.

24.  A method of fabricating a multilayer flexible sheet material adaptable for forming a package, bag, pouch, or the like for containing electrostatically sensitive components comprising the steps of:

(a)  providing a first layer of a flexible heat sealable plastic material;

(b)  coating the surface of said first layer with an antistatic material comprising an electron beam curable mixture;

(c)  curing said antistatic material by exposing it to an electron beam;

(d)  providing a second layer of a flexible plastic material having primary and secondary major surfaces with an electrically conductive material deposited on said primary major surface;

(e)  joining said first and second layers along the primary major surfaces of said second layer and said second ply of said first layer by coating one or both of said primary major surfaces and said second ply with an adhesive and pressing said first and second layers together; and

(f)  curing said thermosetting adhesive by exposing it to an electron beam, said curing steps causing said antistatic material to provide antistatic properties to both of said layers.

25. The method of Claim 22 or 24 in which said thermosetting adhesive and said antistatic material are blended together and coated simultaneously in steps (b) and (e) and are cured simultaneously in steps (c) and (f).

FIG-1

FIG-2

# FIG-3

## FIG-3A

OUTSIDE

INSIDE

36    44    34    32    36"

## FIG-4

OUTSIDE

INSIDE

36'    42    40    44    34'    46    36    32    36"

## FIG-5

OUTSIDE

INSIDE

36     44     33'

34

32

36"

## FIG-6

OUTSIDE

INSIDE

36     44

34     33

32

36"

## FIG-7

OUTSIDE

44

36

34

32

33'

36"

INSIDE

## FIG-8

OUTSIDE

36

46'

32'

46

34'

44

32'

36"

INSIDE